# EUROPÄISCHE PATENTSCHRIFT

(11) **EP 1 182 667 B1**
(45) Veröffentlichungstag und Bekanntmachung des Hinweises auf die Patenterteilung: **05.07.2006**
(21) Anmeldenummer: 01119611.0
(22) Anmeldetag: 17.08.2001
(51) Int. Cl.: G11C 16/34

(54) **System und Verfahren zum sicheren Hochtemperaturbetrieb eines Flash-Speichers**
System and method for secure high-temperature operation of a flash memory
Système et méthode pour le fonctionnement sécurisé à haute température d'une mémoire flash

(30) Priorität: 18.08.2000 DE 10040890
(43) Veröffentlichungstag der Anmeldung: 27.02.2002
(73) Patentinhaber: TRW Automotive Electronics & Components GmbH & Co. KG, 78315 Radolfzell (DE)
(72) Erfinder: Peter, Cornelius, 77815 Bühl (DE)
(74) Vertreter: Degwert, Hartmut

(56) Entgegenhaltungen:
- US-A- 5 896 318
- US-A- 5 925 908
- PATENT ABSTRACTS OF JAPAN vol. 2000, no. 04, 31. August 2000 (2000-08-31) -& JP 2000 011670 A (CANON INC), 14. Januar 2000 (2000-01-14)
- PATENT ABSTRACTS OF JAPAN vol. 017, no. 314 (P-1557), 15. Juni 1993 (1993-06-15) -& JP 05 028788 A (NEC CORP), 5. Februar 1993 (1993-02-05)
- PATENT ABSTRACTS OF JAPAN vol. 2000, no. 07, 29. September 2000 (2000-09-29) -& JP 2000 100193 A (SANYO ELECTRIC CO LTD), 7. April 2000 (2000-04-07)
- PATENT ABSTRACTS OF JAPAN vol. 1999, no. 13, 30. November 1999 (1999-11-30) -& JP 11 232887 A (DENSO CORP), 27. August 1999 (1999-08-27)
- PATENT ABSTRACTS OF JAPAN vol. 1998, no. 05, 30. April 1998 (1998-04-30) -& JP 10 021693 A (NISSAN MOTOR CO LTD), 23. Januar 1998 (1998-01-23)

## Beschreibung

Die Erfindung betrifft ein System und ein Verfahren zum sicheren Hochtemperaturbetrieb eines Flash-Speichers gemäß dem Oberbegriff des Anspruchs 1 bzw. Anspruchs 7., das insbesondere in Verbindung mit Getriebesteuergeräten von Automobilen Verwendung finden kann.

Die Verwendung von Flash-Speichern (z.B. FEPROMs) in Kraftfahrzeugen zum Speichern fahrzeugspezifischer Parameter bietet die Möglichkeit beispielsweise ein Getriebesteuergerät in großen Stückzahlen und damit preisgünstig zu fertigen und erst beim Einbau in einen Fahrzeugtyp zu programmieren. Flash-Speicher weisen eine hohe Speicherdichte auf und lassen sich blockweise löschen, wodurch eine schnelle und einfache Programmierung gewährleistet ist. Der Einsatz solcher Speicher bei hohen Temperaturen von über 100° C, wie sie im Automobilbereich z.B. im Bereich des Getriebes, in dessen Umgebung die Flash-Speicher angebracht werden können, auftreten, bereitet jedoch erhebliche Probleme, da durch die mit der Temperatur exponentiell steigende Elektronenbeweglichkeit die Speicherzellen mit der Zeit ihre Ladung verlieren, wodurch die Haltbarkeitszeit der gespeicherten Daten, die sogenannte "Data Retention Time", abnimmt.

US 5,896,318 offenbart einen Flächenspeicher zur Verwendung in Kraftfahrzeugen. Um trotz der durch die hohen Temperaturen verkürzten Haltbarkeitszeit der gespeicherten Daten die notwendigen Refresh-Vorgänge nicht zu häufig durchführen zu müssen, wird sukzessive jede einzelne Speicherzelle daraufhin überprüft, ob ein baldiger Datenverlust wahrscheinlich ist. Dazu wird auf die Wort-Leitung der zu prüfenden Speicherzelle eine erste Prüfspannung gelegt, und festgestellt, ob die Speicherzelle ON ist und anschließend eine zweite Prüfspannung, mit der überprüft wird, ob die Speicherzelle OFF ist. Die Überprüfungsergebnisse werden in einer zweiten Speichereinheit gespeichert. Damit wird nur für die Speicherzellen ein Refresh-Vorgang durchgeführt, für die ein bevorstehender Datenverlust festgestellt wird. Es wird vorgeschlagen, daß mittels eines Temperatursensors die Umgebungstemperatur des Speichers gemessen wird und ein Wärmebelastungswert daraus ermittelt wird. Überschreitet dieser einen vorher festgelegten Wert, so wird der Prozeß zur Überprüfung auf bevorstehenden Datenverlust ausgelöst.

JP 05 028 788 A offenbart die Überwachung der Daten in einem nichtflüchtigen Speicher mittels Daten zur Überwachung von Datenänderungen, die in einem zweiten Speicher gespeichert sind. Ein Refresh-Vorgang wird durchgeführt, wenn bei der periodischen Überwachung der Daten eine Änderung der Daten festgestellt wird.

In der JP 11 232 887 A wird ein Refresh-Vorgang für ein Flash-ROM nur durchgeführt, wenn die Speicherumgebungstemperatur innerhalb eines vorgegebenen Temperaturbereichs liegt.

Aufgabe der Erfindung ist es daher, ein System und ein Verfahren zum Betrieb eines Flash-Speichers zu schaffen, bei denen das Risiko eines Datenverlustes beim Einsatz unter hohen Temperaturen - wie sie z.B. im Bereich des Getriebes eines Kraftfahrzeugs auftreten - verringert ist.

Um diese Aufgabe zu lösen schafft die Erfindung ein System zum sicheren Hochtemperaturbetrieb eines Flash-Speichers mit dem Merkmalen des Anspruchs 1. Durch die Redundanz der gespeicherten Daten ist die Steuereinheit bei einem Fehler in einem Datensatz erstens in der Lage auf einen anderen Datensatz ausweichen und zweitens den fehlerhaften Datensatz anhand des anderen Datensatzes zu reparieren. Weiterhin verringert das regelmäßige Auffrischen des Speicherinhaltes das Risiko eines thermisch bedingten Datenverlustes.

Die Aufgabe der Erfindung wird weiterhin durch ein entsprechendes Verfahren gemäß Anspruch 7 gelöst.

Weitere Ausgestaltungen und Vorteile der Erfindung ergeben sich aus den Unteransprüchen.

Die Erfindung wird nachfolgend anhand einer bevorzugten Ausführungsform beschrieben, wobei Bezug genommen wird auf die beigefügten Zeichnungen. Darin zeigt:
Fig. 1 ein Blockschaltbild eines erfindungsgemäßen Systems zum sicheren Hochtemperaturbetrieb eines Flash-Speichers;
Fig. 2 schematisch ein Fahrzeuggetriebe, bei dem das in der Fig. 1 dargestellte System eingesetzt wird.

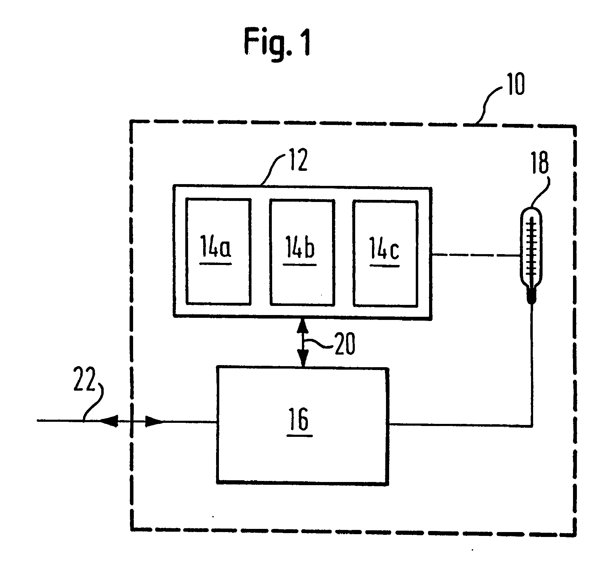

Das in Fig. 1 dargestellte System 10 weist einen Flash-Speicher 12, der in drei Blöcken 14a, 14b und 14c organisiert ist, eine Steuereinheit 16 und einen Temperatursensor 18, der in thermischem Kontakt mit dem Flash-Speicher 12 oder dessen nächster Umgebung steht, auf. Der Temperatursensor 18 ist mit der Steuereinheit 16 verbunden, und liefert dieser laufend Signale, die die aktuellen Temperaturwerte repräsentieren. Die Steuereinheit, die z.B. einen nicht dargestellten Prozessor mit ROM-Speicher enthalten kann, wandelt diese Signale in digitale Temperaturwerte um. Die Steuereinheit 16 kann über die schematisch dargestellten Steuer- und Datenleitungen 20 jeden der drei Blöcke 14a, 14b, 14c einzeln löschen, beschreiben (programmieren) und auslesen. Darüber hinaus steht die Steuereinheit 16 über Leitungen 22 mit anderen, in Fig. 1 nicht dargestellten Einheiten außerhalb des Systems 10 in Verbindung, mit denen sie Befehle und Daten austauschen kann.

In den drei Blöcken 14a, 14b, 14c sind jeweils identische Datensätze gespeichert, die vorzugsweise jeweils um ebenfalls in den Blöcken abgelegte Prüfsummen ergänzt sind.

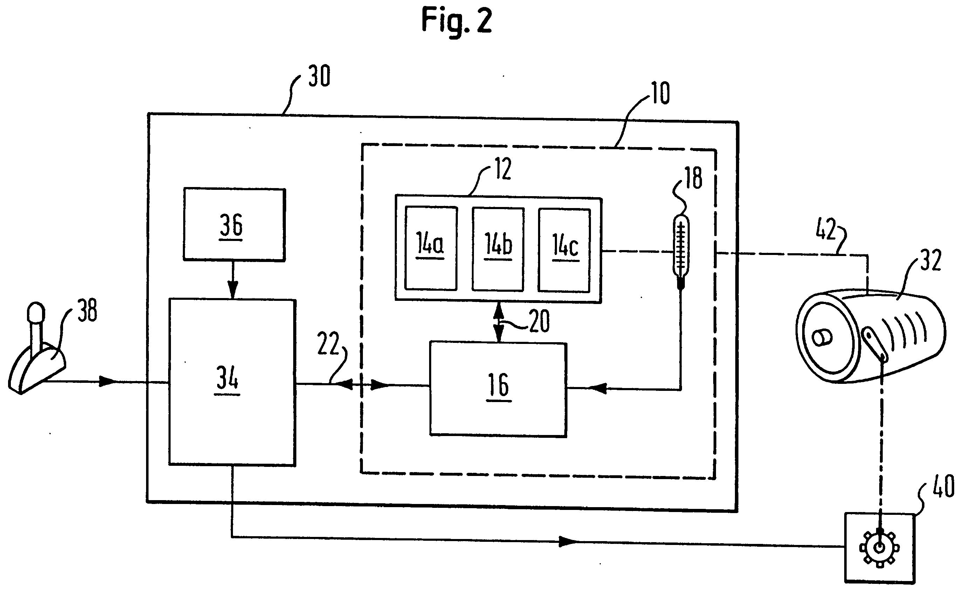

Eine beispielhafte Anwendung für das System 10 ist in Fig. 2 dargestellt. Hier ist ein erfindungsgemäßes Getriebesteuergerät 30 an einem Getriebe 32 eines Kraftfahrzeuges angebracht. Das Getriebesteuergerät 30 besteht aus dem System 10 aus Fig. 1, einem Mikrocontroller 34 und einem Festwertspeicher (ROM) 36. Das Getriebesteuergerät 30 ist mit einem Wählhebel 38 und einem Stellmotor 40 für das Getriebe 32 elektrisch verbunden. Im ROM 36 ist das Betriebssystem für den Mikrocontroller 34 gespeichert, der mit der Steuereinheit 16 verbunden ist. Im Flash-Speicher 12 sind die optimalen Parameter und Programme zum Wechsel der Getriebestufen abgelegt.

Das Getriebesteuergerät 30 hat die Aufgabe, das Getriebe 32 gemäß der Anforderung vom Wählhebel 38 optimal zu steuern. Dazu erhält die Steuereinheit vom Wählhebel 38 die Anforderung, das Getriebe 32 in eine höhere oder eine niederere Stufe zu schalten, oder die automatische Steuerung des Getriebes zu übernehmen. Anhand der im Flash-Speicher 12 abgelegten Daten steuert der Mikrocontroller 34 dann den Stellmotor 40 zum Wechsel der Getriebestufen an. Da das Getriebesteuergerät 30 und damit auch das System 10 in direktem thermischen Kontakt 42 zum Getriebe 32 stehen, ist der Flash-Speicher 12 den Temperaturen des Getriebeöls ausgesetzt, die typischerweise bis zu 140 ° C betragen und durch Strahlungseinflüsse eines u.U. in der Nähe angebrachten Katalysators bis zu 150° C erreichen können.

Beim Einschalten der Zündung wird das System 10 durch den Mikrocontroller 34 vom passiven in den aktiven Zustand versetzt, in welchem es die Parameter und Programme zum Wechsel der Getriebestufen an den Mikrocontroller 34 übergeben kann. Beim Eintritt in den aktiven Zustand führt die Steuereinheit 16 eine Konsistenzprüfung der im Flash-Speicher gespeicherten Datensätze anhand von diesen zugeordneten gespeicherten Prüfsummen aus. Die Prüfsummen erlauben eine schnelle Überprüfung der Datensätze auf Korrektheit. Es besteht aber auch die Möglichkeit, die Daten der einzelnen Blöcke 14a, 14b, 14c byteweise miteinander zu vergleichen. Die Konsistenzprüfung kann auch sukzessive erfolgen, wobei erst die Prüfsumme überprüft wird und dann, wenn ein Fehler in der Prüfsumme festgestellt wurde, die byteweise Überprüfung erfolgt. Falls die Prüfung ergibt, daß alle Daten in Ordnung sind, kann die Steuereinheit 16 einen beliebigen Datensatz zur Steuerung des Getriebes 32 übergeben. Falls sich bei der Prüfung Fehler in den Datensätzen ergeben, dann wählt die Steuereinheit einen Datensatz zur Steuerung des Getriebes aus, der keine Fehler aufweist.

Beim anschließenden Ausschalten der Zündung geht das System 10 wieder in den passiven Zustand über. Dann wird gegebenenfalls ein fehlerhafter Datensatz von der Steuereinheit 16 repariert, indem der gesamte fehlerhafte Datensatz gelöscht und mit den Daten aus einem der fehlerfreien Datensätze wieder beschrieben wird. Diese Reparatur findet jedoch erst dann statt, wenn die mittels des Temperatursensors 18 überwachte Temperatur des Flash-Speichers unter einen bestimmten Temperaturgrenzwert, in diesem Fall von 120° C gesunken ist, wobei der Temperaturgrenzwert so ausgewählt ist, das ein sicherer Lösch-/und Programmiervorgang des Flash-Speichers gesichert ist. Oberhalb einer Temperatur von 120°C werden keine Schreib- und Löschvorgänge durchgeführt, um eine zusätzliche Belastung des Flash-Speichers und das damit verbundene Risiko von Datenverlusten zu vermeiden.

Für den unwahrscheinlichen Fall, daß alle drei Datensätze Fehler aufweisen, kann der Microcontroller 34 das Getriebe anhand eines nicht optimierten Notprogrammes steuern, welches im ROM 36 abgelegt ist.

Darüber hinaus wird von der Steuereinheit 16 ständig ein kumulierter Wärmebelastungswert für die Daten im Flash-Speicher bestimmt. Dazu integriert die Steuereinheit 16 die von dem Temperatursensor 18 erfasste und an die Steuereinheit 16 übermittelte Temperatur des Flash-Speichers 12 über die Zeit, wobei jeder Temperaturwert mit einem temperaturabhängigen Bewertungsfaktor versehen wird. Die Bewertungsfaktoren können beispielsweise dadurch bestimmt werden, daß für jeden Temperaturwert die Mindestzeit ermittelt wird, während der die Daten bei konstanter Temperatur fehlerfrei gespeichert bleiben.

Überschreitet der durch die Integration erhaltene Wärmebelastungswert einen vorherbestimmten Wärmebelastungsgrenzwert (der z.B. einer Belastung des Flash-Speichers von 120° C über 30 Std., von 130° C über 10 Std., von 140° C über 3 Std. oder 150° C über 1 Std. entsprechen kann bzw. entsprechenden Kombinationen aus Zwischentemperaturen und Zeiten), für den mit hinreichender Wahrscheinlichkeit ein völliger Datenverlust ausgeschlossen werden kann, dann führt die Steuereinheit 16 einen Auffrischvorgang (Refresh) durch, sobald sich das System 10 im passiven Zustand befindet und die überwachte Temperatur des Flash-Speichers 12 unter den Temperaturgrenzwert gesunken ist. Dabei werden zunächst alle Blöcke 14a, 14b, 14c wie oben erläutert durch eine Konsistenzprüfung auf Fehlerfreiheit hin überprüft. Danach wird ein erster Block ausgewählt, dessen Datensatz vollständig gelöscht und der Block mit dem Datensatz eines benachbarten fehlerfreien Blockes wieder beschrieben. Anschließend wird derselbe Vorgang mit dem nächsten Block durchgeführt, solange bis alle Blöcke neu beschrieben sind. Nach diesem Auffrischen wird die Integration des Wärmebelastungswertes neu gestartet. Ist bei der Überprüfung der Datensatz eines Blockes als fehlerhaft erkannt worden, dann wird dieser Block als erster ausgewählt, gelöscht und neu programmiert, damit wenigstens ein fehlerfreier Datensatz erhalten bleibt. Auf diese Weise wird der fehlerhafte Datensatz unter Ausnutzung der Redundanz der Daten im Zuge des Auffrischens wie oben beschrieben repariert.

Wird das System 10 während der Reparatur oder dem Auffrischen eines Datensatzes vom passiven in den aktiven Zustand versetzt, dann unterbricht die Steuereinheit 16 den Reparatur- oder Auffrischvorgang und setzt diesen erst dann fort, wenn sich das System 10 wieder im passiven Zustand befindet und die mittels des Temperatursensors 18 überwachte Temperatur des Flash-Speichers unter einen bestimmten Temperaturgrenzwert, in diesem Fall 120° C gesunken ist.

Das regelmäßige Auffrischen des Speicherinhalts verringert das Risiko eines Datenverlustes, wobei durch die Anpassung der Zeit zwischen zwei aufeinanderfolgenden Auffrischvorgängen, also der Zykluszeit, in Abhängigkeit von den Temperaturen, denen der Flash-Speicher seit dem letzten Auffrischen ausgesetzt war, die Anzahl der Schreib- und Löschvorgänge optimiert werden kann. Damit können die Belastung des Speichers und auch der Stromverbrauch der System minimiert werden, wobei die Lebensdauer des Flash-Speichers maximiert wird.

## Patentansprüche

1. System (10) zum sicheren Hochtemperaturbetrieb eines Flash-Speichers (12) mit
- einem Temperatursensor (18), der eine die Temperatur des Flash-Speichers charakterisierende Temperatur mißt, und
- einer mit dem Temperatursensor und dem Flash-Speicher verbundenen Steuereinheit (16), die einen Zeitgeber umfaßt und so ausgebildet ist, daß sie die Temperatursignale vom Temperatursensor empfangen und durch Integration der daraus ermittelten Temperaturwerte über die Zeit einen kumulierten Wärmebelastungswert des Flash-Speichers ermitteln kann
**dadurch gekennzeichnet, daß**
der Flash-Speicher vor dem Hochtemperaturbetrieb so programmiert ist, daß jeder Datensatz in dem Flash-Speicher redundant abgespeichert ist, und daß die Steuereinheit (16),
- wenn der kumulierte Wärmebelastungswert einen vorherbestimmten Wärmebelastungsgrenzwert überschreitet und
- die aktuelle den Flash-Speicher charakterisierende Temperatur einen vorherbestimmten Temperaturgrenzwert unterschreitet, der so gewählt ist, daß ein sicherer Lösch-/Programmierbetrieb des Flash-Speichers möglich ist,
- die Datensätze auf Konsistenz prüfen kann, wobei die Steuereinheit dann,
- wenn sie Konsistenz eines Datensatzes festgestellt hat, einen Refresh der zu dem Datensatz gehörenden Speicherzellen des Flash-Speichers durchführen kann und dann,
- wenn sie festgestellt hat, daß einer der redundant abgespeicherten Datensätze nicht konsistent zu dem oder den entsprechenden dazu passenden anderen Datensätzen ist, anhand eines korrekten Datensatzes durch Neuprogrammieren den inkorrekten Datensatz so in dem Flash-Speicher wiederherstellen kann, daß er konsistent zu dem korrekten Datensatz ist.

2. System nach Anspruch 1, **dadurch gekennzeichnet, daß** die Datensätze jeweils mit einer Prüfsumme versehen sind, die zur Konsistenzprüfung herangezogen wird.

3. System nach Anspruch 1 oder 2, **dadurch gekennzeichnet, daß** die Datensätze zur Gewährleistung der Redundanz im Flash-Speicher mehrfach identisch abgespeichert sind.

4. System nach Anspruch 3, **dadurch gekennzeichnet, daß** die Steuereinheit so ausgebildet ist, daß sie die mehrfach abgespeicherten Datensätze durch byteweises Vergleichen auf Konsistenz prüfen kann.

5. Getriebesteuergerät (32) mit einem System nach einem der Ansprüche 1 bis 4.

6. Getriebe (30), das mit einem Getriebesteuergerät (32) nach Anspruch 5 verbunden ist.

7. Verfahren zum sicheren Hochtemperaturbetrieb eines Flash-Speichers (12) mit den folgenden Schritten
- es wird eine die Temperatur des Flash-Speichers charakterisierende Temperatur gemessen, und
- es werden die gemessenen Temperaturwerte über die Zeit integriert, um einen kumulierten Wärmebelastungswert des Flash-Speichers zu ermitteln,
**dadurch gekennzeichnet, daß**
der Flash-Speicher (12) vor dem Hochtemperaturbetrieb so programmiert ist, daß jeder Datensatz in dem Flash-Speicher redundant abgespeichert ist, und daß das Verfahren folgende Schritte umfaßt
- es werden, wenn der kumulierte Wärmebelastungswert einen vorherbestimmten Wärmebelastungsgrenzwert überschreitet
- und die aktuelle den Flash-Speicher charakterisierende Temperatur einen vorherbestimmten Temperaturgrenzwert unterschreitet, der so gewählt ist, daß ein sicherer Lösch-/Programmierbetrieb des Flash-Speichers möglich ist,
die Datensätze auf Konsistenz geprüft, wobei dann,
- wenn die Konsistenz eines Datensatzes festgestellt wird ein Refresh der zu dem Datensatz gehörenden Speicherzellen des Flash-Speichers durchgeführt wird und dann,
- wenn festgestellt wird, daß einer der redundant abgespeicherten Datensätze nicht konsistent zu dem oder den entsprechenden dazu passenden anderen Datensätzen ist, anhand eines korrekten Datensatzes durch Neuprogrammieren der inkorrekte Datensatz so in dem Flash-Speicher wiederhergestellt wird, daß er konsistent zu dem korrekten Datensatz ist.

## Claims

1. A system (10) for safe high-temperature operation of a flash memory (12) comprising:
- a temperature sensor (18) sensing a temperature characterizing the temperature of the flash memory, and
- a control unit (16) connected to the temperature sensor and to the flash memory, the control unit comprising a timer and being configured such that it is able to receive the temperature signals from the temperature sensor and to establish a cumulated heat load value of the flash memory by integrating the temperature values determined therefrom versus time,
**characterized in that**
prior to high-temperature operation, the flash memory is programmed such that each set of data in the flash memory is stored redundantly, and that
- when the cumulated heat load value exceeds a predefined heat load limit, and
- the current temperature characterizing the flash memory drops below a predefined temperature limit selected such that a safe clearing/programming operation of the flash memory is possible,
- the control unit (16) is able to check the sets of data for consistency, the control unit,
- when it has established consistency of a data set, being able to carry out a refresh of the storage cells of the flash memory which are associated with the data set and,
- when it has established that one of the redundantly stored sets of data is not consistent with the one or more corresponding other sets of data matching therewith, being able to recover the incorrect data set in the flash memory by reprogramming on the basis of a correct data set such that it is consistent with the correct data set.

2. The system as set forth in claim 1, **characterized in that** each of the sets of data is provided with a checksum which is made use of for checking consistency.

3. The system as set forth in claim 1 or 2, **characterized in that** the sets of data are stored in multiple identical copies in the flash memory for ensuring redundancy.

4. The system as set forth in claim 3, **characterized in that** the control unit is configured such that it is able to check the multiply stored sets of data for consistency by bytewise comparison.

5. A transmission controller (32) including a system as set forth in any of claims 1 to 4.

6. A transmission (30) connected to a transmission controller (32) as set forth in claim 5.

7. A method for safe high-temperature operation of a flash memory (12) comprising the following steps:
- sensing a temperature characterizing the temperature of the flash memory, and
- integrating the sensed temperature values versus time to establish a cumulated heat load value of the flash memory,
**characterized in that**
prior to high-temperature operation, the flash memory (12) is programmed such that each set of data in the flash memory is stored redundantly, and that the method comprises the following steps:
checking the sets of data for consistency
- when the cumulated heat load value exceeds a predefined heat load limit, and
- the current temperature characterizing the flash memory drops below a predefined temperature limit selected such that safe clearing/programming operation of the flash memory is possible,
- when consistency of a data set is established, there being carried out a refresh of the storage cells of the flash memory which are associated with the data set, and
- when it is established that one of the redundantly stored sets of data is not consistent with the one or more corresponding other sets of data matching therewith, the incorrect data set in the flash memory being recovered by reprogramming on the basis of a correct data set such that it is consistent with the correct data set.

## Revendications

1. Système (10) pour l'exploitation à haute température et en toute sécurité d'une mémoire flash (12), comportant
un capteur de température (18) qui mesure une température caractérisant la température de la mémoire flash, et
une unité de commande (16) reliée au capteur de température et à la mémoire flash, qui comprend une horloge et qui est conçue de façon qu'elle puisse recevoir les signaux de température du capteur de température et déterminer une valeur cumulée de charge thermique de la mémoire flash par intégration des valeurs sur le temps,
**caractérisé en ce que**
la mémoire flash est programmée avant l'exploitation à haute température de telle sorte que chaque groupement de données est mémorisé de façon redondante dans la mémoire flash, et **en ce que** l'unité de commande (16),
- lorsque la valeur cumulée de charge thermique dépasse une valeur limite de charge thermique qui est prédéfinie auparavant et,
- lorsque la température actuelle caractérisant la mémoire flash passe au-dessous d'une valeur limite de température définie auparavant qui est choisie de telle sorte qu'elle permet un mode sûr d'effacement/programmation de la mémoire flash,
- peut contrôler la consistance des groupements de données, l'unité de commande pouvant alors effectuer
- un rafraîchissement des cellules de mémoire de la mémoire flash appartenant au groupement de données, lorsqu'elle a constaté la consistance d'un groupement de données, et
lorsqu'elle a constaté que l'un des groupements de données mémorisé de façon redondante n'est pas consistant par rapport au groupement de données ou aux autres groupements de données adaptés de manière correspondante, peut reconstituer le groupement de données incorrect dans la mémoire flash par reprogrammation sur la base d'un groupement de données correct, de telle sorte qu'il soit consistant par rapport à un groupement de données correct.

2. Système selon la revendication 1, **caractérisé en ce que** les groupements de données sont dotés chacun d'une somme totale de contrôle qui est mise à contribution pour le contrôle de la consistance.

3. Système selon la revendication 1 ou 2, **caractérisé en ce que** les groupements de données sont mémorisés plusieurs fois de façon identique dans la mémoire flash pour assurer la redondance.

4. Système selon la revendication 3, **caractérisé en ce que** l'unité de commande est réalisée de manière à pouvoir contrôler les groupements de données mémorisés plusieurs fois par une comparaison byte par byte.

5. Appareil de commande d'engrenage (32) comportant un système selon l'une des revendications 1 à 4.

6. Engrenage (30), qui est relié à un appareil de commande d'engrenage selon la revendication 5.

7. Procédé pour l'exploitation à haute température et en toute sécurité d'une mémoire flash (12), comportant les étapes suivantes :
- on mesure une température caractérisant la température de la mémoire flash et,
- on intègre sur le temps les valeurs de température mesurées en fonction du temps, afin de déterminer une valeur cumulée de charge thermique de la mémoire flash,
**caractérisé en ce que**
la mémoire flash (12) est programmée avant l'exploitation à une température élevée de telle sorte que chaque groupement de données est mémorisé de façon redondante dans la mémoire flash, et **en ce que** le procédé comprend les étapes suivantes :
- lorsque la valeur cumulée de charge thermique dépasse une valeur limite de charge thermique définie auparavant,
et la température actuelle qui est choisie de façon à permettre un mode sûr d'effacement/programmation de la mémoire flash, on contrôle la consistance des groupements de données,
- lorsque la consistance d'un groupement de données est constatée, on effectue un rafraîchissement des cellules de mémoire appartenant au groupement de données, de la mémoire flash, et
- lorsqu'on constate que l'un des groupements de données mémorisés de façon redondante n'est pas consistant par rapport au groupement ou aux autres groupements correspondants adapté, on reconstitue le groupement incorrect par reprogrammation sur la base d'un groupement de données correct dans la mémoire flash de telle façon qu'il soit consistant par rapport au groupement de données correct.
